# EUROPÄISCHE PATENTSCHRIFT

(11) **EP 0 869 614 B1**
(45) Veröffentlichungstag und Bekanntmachung des Hinweises auf die Patenterteilung: **08.08.2001**
(21) Anmeldenummer: 98105129.5
(22) Anmeldetag: 20.03.1998
(51) Int. Cl.: H03K 19/00, H03K 19/0185

(54) **Eingangsverstärker für Eingangssignale mit steilen Flanken**
Input amplifier for input signals with steep edges
Amplificateur pour des signaux à front raide

(30) Priorität: 03.04.1997 DE 19713832
(43) Veröffentlichungstag der Anmeldung: 07.10.1998
(73) Patentinhaber: Infineon Technologies AG, 81669 München (DE)
(72) Erfinder: Sichert, Christian, 81827 München (DE); Manyoki, Zoltan, 81739 München (DE)
(74) Vertreter: Zedlitz, Peter, Dipl.-Inf.

(56) Entgegenhaltungen:
- EP-A- 0 621 694
- JP-A- 6 029 825
- US-A- 5 440 248
- US-A- 5 488 322

## Beschreibung

Die Erfindung betrifft einen Eingangsverstärker für Eingangssignale mit steilen Flanken (insbesondere "High-Low-Flanken"), mit mindestens einem Transistor, der eine mit einem Ausgang verbundene Elektrode hat.

CMOS-Eingangsverstärker sind seit längerem bekannt und werden für die vielfältigsten Schaltungszwecke eingesetzt. So ist ein Eingangsverstärker der eingangs genannten Art beispielsweise in dem Fachbuch "CMOS-Analog Circuit Design" von P.E. Allen und D.R. Holberg, auf Seite 381 beschrieben.

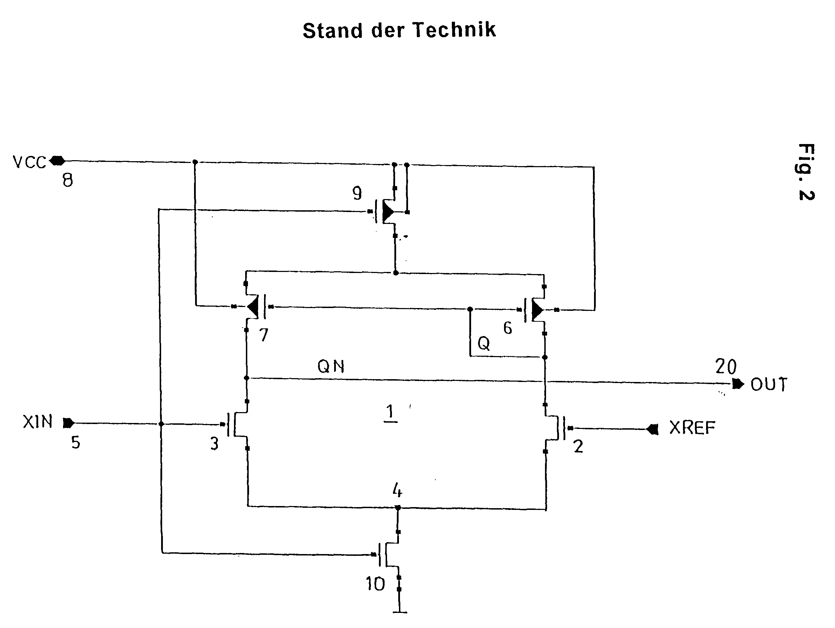

Fig. 2 zeigt einen solchen bekannten Eingangsverstärker aus einem Differenzverstärker 1 mit N-Kanal-MOS-Transistoren 2, 3 und P-Kanal-MOS-Transistoren 6, 7, einem P-Kanal-MOS-Transistor 9 und einem N-Kanal-MOS-Transistor 10. Gates der Transistoren 9, 10 und ein Eingang IN des Differenzverstärkers 1 sind mit einem Eingangsanschluß 5 verbunden, an welchem ein Eingangssignal XIN liegt, während die Source-Drain-Strecke des Transistors 9 mit einem Anschluß 8 für eine Betriebsspannung VCC verbunden ist. Außerdem ist der Differenzverstärker 1 mit einer Bezugsspannung XREF beaufschlagt und mit einem Ausgangsanschluß 20 zur Abgabe eines Ausgangssignals OUT verbunden.

Verwendungsmöglichkeiten für solche bekannte Eingangsverstärker sind beispielsweise LVTTL-Schaltungen (LVTTL = Low Voltage-Transistor-Transistor-Logik) und SSTL-Logik-Schaltungen (SSTL = Stub-Series-Terminated-Logic). In LVTTL-Logik-Schaltungen treten Spannungsanstiegs- und -abfallflanken von etwa 0,8 V bis 2,0 V auf, während die SSTL-Logik-Schaltungen entsprechende Anstiegs- und -abfallflanken von etwa 400 mV um einen Referenzwert haben.

In beiden Logikschaltungen, also den LVTTL-Logik-Schaltungen und den SSTL-Logik-Schaltungen, sind die Spannungsabfallflanken sehr steil, so daß entsprechend schnelle Eingangsflanken vorliegen. Sind nun auf einem Chip zahlreiche Eingangsverstärker vorgesehen, so sollen in einem stromsparenden Betriebsmodus möglichst viele von diesen deaktiviert werden, damit sie keinen Strom konsumieren. Darüber hinaus ist es wünschenswert, die aktiv gebliebenen Eingangsempfänger durch die Eingangssignale in einen stromfreien Zustand zu bringen. Es sollen jedenfalls nur die Schaltungen tatsächlich aktiv sein, die angesteuert sind.

Es hat sich nun aber gezeigt, daß bei steilen Flanken der Eingangssignale der Eingangsverstärker viel zu schnell in einen stromfreien Endzustand gerät, so daß ein Schalten des Ausgangssignals verhindert wird.

Um dieses Problem zu lösen, wurde bisher daran gedacht, asymmetrische Eingangsverstärker einzusetzen, um dadurch den Schaltvorgang schnell genug zu machen, daß er abgeschlossen ist, bevor der Endzustand erreicht wird. Diese Dimensionierung hat aber zur Folge, daß im ungünstigen Fall der Gleichstromverbrauch ("Worst-care DC consumption") erhöht ist.

Es ist daher **Aufgabe** der vorliegenden Erfindung, einen Eingangsverstärker zu schaffen, der auch bei schnellen Eingangsflanken zuverlässig schalten kann.

Zur Lösung dieser Aufgabe schafft die vorliegende Erfindung einen Eingangsverstärker der eingangs genannten Art, der gekennzeichnet ist durch eine Einrichtung, die ein frühzeitiges vollständiges Abschalten des Eingangsverstärkers verhindert, so daß der Eingangsverstärker erst abgeschaltet wird, nachdem das Eingangssignal bewertet worden ist.

Der erfindungsgemäße Eingangsverstärker zeichnet sich dadurch aus, daß
- im stationären Zustand, bei einem genügend niedrigen bzw. hohen Eingangspegel kein Strom durch den Verstärker fließt und
- nach dem Schalten von einem Ausgangszustand in den anderen der Strom durch den Verstärker mittels der Rückkopplung des Ausgangssignals erst abgeschaltet wird, nachdem das Eingangssignal bewertet worden ist.

In bevorzugter Weise ist die Einrichtung ein Verzögerungsglied über das der Ausgang zur Stromversorgung des Verstärkers rückgekoppelt ist.

Nachfolgend wird die Erfindung anhand der Zeichnung näher erläutert. Es zeigen:
- Fig. 1: ein Schaltbild des erfindungsgemäßen Eingangsverstärkers, und
- Fig. 2: ein Schaltbild eines herkömmlichen Eingangsverstärkers.

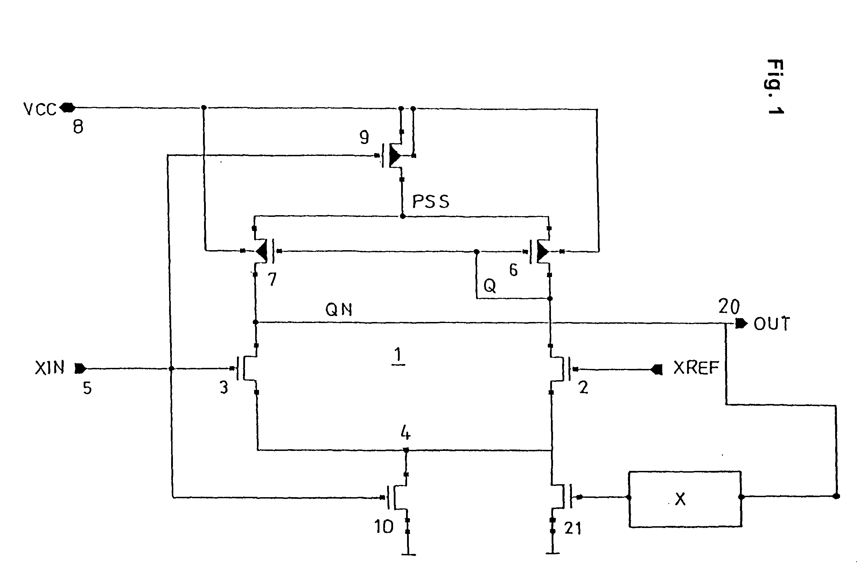

Fig. 2 ist bereits eingangs erläutert worden. In der Fig. 1 sind einander entsprechende Bauteile mit den gleichen Bezugszeichen wie in Fig. 2 versehen.

Ein Differenzverstärker 1 besteht aus einem an seinem Gate mit einer Bezugsspannung XREF beaufschlagten N-Kanal-MOS-Transistor 2 und einem bezüglich eines Knotens 4 hierzu symmetrisch liegenden N-Kanal-MOS-Transistor 3. Einem Eingangsanschluß 5, der mit Gate des Transistors 3 verbunden ist, ist ein Eingangssignal XIN zugeführt. Drains der Transistoren 2, 3 sind mit Stromspiegel-P-Kanal-MOS-Transistoren 6, 7 verbunden. Eine Betriebsspannung VCC liegt von einem Anschluß 8 an einem P-Kanal-MOS-Transistor 9, dessen Gate das Eingangssignal XIN zugeführt ist. Der Transistor 9 und ein N-Kanal-MOS-Transistor 10, dessen Source beziehungsweise Drain mit dem Knoten 4 verbunden ist und an dessen Gate das Eingangssignal XIN von dem Eingangsanschluß 5 liegt, wirken als Inverter. Gate des Transistors 6 ist mit einem Knoten Q zwischen den Transistoren 2 und 6 und mit Gate des Transistors 7 verbunden. Außerdem ist ein Knoten QN zwischen den Transistoren 3 und 7 mit einem Ausgangsanschluß 20 zur Lieferung eines Ausgangssignals OUT verbunden.

Die Transistoren 9, 10 dienen dazu, einen bei hohen Spannungshüben im Differenzverstärker 1 fließenden Querstrom abzuschalten.

Die Transistoren 3, 7 sind symmetrisch zu den Transistoren 2, 6. Der Stromspiegel aus den Transistoren 6 und 7 kann auch mit N-Kanal-Transistoren realisiert werden; analog können die Eingangstransistoren 2, 3 P-Kanal-MOS-Transistoren sein.

Am Eingangsanschluß 5 liegt beispielsweise ein Eingangssignal, das in der LVTTL-Logik steil von etwas über 2,0 V auf unter 0,8 V abfällt.

Eine "Hoch-Niedrig-Spannungsflanke" der genannten Art schaltet bei einer Schaltung, wie diese oben bisher beschrieben ist, den Transistor 10 ab, wodurch der Knoten Q in seiner Spannung durch den Transistor 6 nach oben gezogen wird. Hierdurch wird wiederum auch der Transistor 7 abgeschaltet, der an sich aber den Knoten QN spannungsmäßig nach oben ziehen sollte. Mit anderen Worten, der bisher beschriebene Eingangsverstärker arbeitet bei Eingangssignalen mit steilen Flanken nicht zufriedenstellend.

Um ein solches befriedigendes Arbeiten auch bei derartigen Eingangssignalen mit steilen Flanken zu gewährleisten, hat der erfindungsgemäße Eingangsverstärker zusätzlich (vergleiche die Strichlinie 11 in Fig. 2) noch eine Einrichtung X, die ein frühzeitiges vollständiges Abschalten des Differenzverstärkers 1 bzw. des Transistors 7 verhindert.

Diese Einrichtung X besteht aus einem invertierenden Verzögerungsglied, über das das durch den Eingangsverstärker bewertete Signal zur Stromversorgung des Verstärkers rückgekoppelt wird. Dieser Einrichtung X kann, wie ebenfalls in Fig. 1 gezeigt ist, ein als Stromquelle wirkender N-Kanal-MOS-Transistor 21 nachgeschaltet sein, der an Gate mit dem verzögerten Ausgangssignal beaufschlagt ist und mit seiner Drain-Source-Strecke zwischen dem Knoten 4 und Masse liegt.

Bei dem erfindungsgemäßen Eingangsverstärker ist der Transistor 21 über die Rückkopplungsschleife von dem Eingangssignal XIN bereits aktiv. Damit wird ein Strom durch den Transistor 21 geführt. Dies bedeutet wiederum, daß die Spannung am Knoten Q langsamer steigt, so daß die Spannung am Knoten Q über den Transistor 7 nach oben gezogen werden kann.

Auf diese Weise ermöglicht der erfindungsgemäße Eingangsverstärker ein Schalten von Signalen mit sehr schnellen Flanken, so daß zuverlässig ein Abschalten vorgenommen werden kann. Der Schaltungsaufwand, der zusätzlich zu dem bestehenden Eingangsverstärker erforderlich ist, ist äußerst gering, da lediglich das Verzögerungsglied X und der weitere Transistor 21 benötigt werden.

## Patentansprüche

1. Eingangsverstärker für Eingangssignale (XIN) mit steilen Flanken, mit
- einem Differenzverstärker (1), der einen ersten Transistor (3), der ein Eingangssignal (XIN) empfängt, einen zweiten Transistor (2), der ein Referenzsignal (XREF) empfängt sowie einen dritten und vierten Transistor (6, 7), die einen Stromspiegel bilden, aufweist, wobei ein Knoten zwischen erstem und drittem Transistor (3, 7) mit einem Ausgang (20) des Eingangsverstärkers verbunden ist,
- einem fünften Transistor (9), der zwischen dem Differenzverstärker (1) und der Betriebsspannung (VCC) angeordnet ist, und
- einem sechsten Transistor (10), der zwischen dem Differenzverstärker (1) und Masse angeordnet ist,
dadurch **gekennzeichnet**, dass
der Ausgang (OUT) des Eingangsverstärkers über ein Verzögerungsglied (X) mit einem als Stromquelle wirkenden weiteren Transistor (21) verbunden ist, der dem sechsten Transistor (10) parallel geschaltet ist.

## Claims

1. Input amplifier for input signals (XIN) with steep edges, having
- a differential amplifier (1) which contains a first transistor (3), which receives an input signal (XIN), a second transistor (2), which receives a reference signal (XREF), and also a third and a fourth transistor (6, 7), which form a current mirror, a node between the first and third transistors (3, 7) being connected to an output (20) of the input amplifier,
- a fifth transistor (9), which is arranged between the differential amplifier (1) and the operating voltage (VCC), and
- a sixth transistor (10), which is arranged between the differential amplifier (1) and earth,
characterized in that
the output (OUT) of the input amplifier is connected via a delay element (X) to a further transistor (21), which acts as a current source and is connected in parallel with the sixth transistor (10).

## Revendications

1. Amplificateur d'entrée pour signaux d'entrée (XIN) à flancs raides, avec
- un amplificateur différentiateur (1) qui comporte un premier transistor (3), lequel reçoit un signal d'entrée (XIN), un deuxième transistor (2), lequel reçoit un signal de référence (XREF), ainsi qu'un troisième et un quatrième transistor (6, 7), lesquelles forment un miroir de courant, un noeud entre le premier et le troisième transistor (3, 7) étant relié à une sortie (20) de l'amplificateur d'entrée,
- un cinquième transistor (9), qui est disposé entre l'amplificateur différentiateur (1) et la tension de service (VCC), et
- un sixième transistor (10), qui est disposé entre l'amplificateur différentiateur (1) et la masse
**caractérisé par le fait que**
la sortie (OUT) de l'amplificateur différentiateur est reliée, à travers un élément temporisateur (X) à un autre transistor (21), qui fonctionne comme source de courant et qui est monté en parallèle sur le sixième transistor (10).
